# FASCICULE DE BREVET EUROPEEN

(11) **EP 1 780 552 B1**
(45) Date de publication et mention de la délivrance du brevet: **10.09.2008**
(21) Numéro de dépôt: 06301074.8
(22) Date de dépôt: 23.10.2006
(51) Int. Cl.: G01R 31/12

(54) **Dispositif électronique pour détecter des anomalies dans des faisceaux électriques d'un véhicule automobile**
Elektronische Einrichtung zur Erkennung der Anomalien elektrischer Kabelbäume eines Fahrzeuges
Electronic device for diagnosing anomalies in electrical harnesses of a motor vehicle

(30) Priorité: 25.10.2005 FR 0553242
(43) Date de publication de la demande: 02.05.2007
(73) Titulaire: Peugeot Citroën Automobiles SA, 78943 Vélizy-Villacoublay Cedex (FR)
(72) Inventeur: Ferlin, Christophe PEUGEOT CITROEN AUTOMOBILES SA, 78960, VOISINS LE BRETONNEUX (FR); Boucly, Bernard PEUGEOT CITROEN AUTOMOBILES SA, 78150, LE CHESNAY (FR)
(74) Mandataire: Fernandez, Francis Lionel

(56) Documents cités:
- EP-A- 0 898 173
- US-A- 4 684 887
- US-A1- 2003 137 309

## Description

La présente invention concerne un dispositif électronique permettant de détecter des anomalies dans des faisceaux électriques d'un véhicule automobile.

Dans toute installation électrique, les lignes d'alimentation électrique sont protégées par des fusibles pour protéger les organes électriques, électroniques et/ou électromécaniques en cas de court-circuit ou de tout autre type de disfonctionnement ou d'anomalie qui pourrait se produire dans les lignes d'alimentation ou dans les organes. Les fusibles sont dimensionnés généralement selon l'intensité du courant de court-circuit, qui constitue le plus grand risque aussi bien pour les organes que pour les lignes d'alimentation et qu'il faut donc éviter.

Toutefois, des courts-circuits francs, c'est-à-dire des courts-circuits qui surviennent si rapidement que leur seule caractéristique est l'intensité du courant de court-circuit, se présentent seulement lorsque l'organe alimenté a une résistance purement ou quasi purement ohmique. Dans les autres cas, le court-circuit est impédant, c'est-à-dire il présente un profil de courant dans le temps avec une valeur maximale moins élevée que les mesures pourraient laisser penser dans un premier temps. Dans une telle situation, l'efficacité de la protection par un fusible n'est donc pas garantie.

Le phénomène de court-circuit impédant est présent au début de chaque court-circuit, le temps nécessaire pour les différentes résistances de produire leur effet de limitateur de courant selon la caractéristique électrique individuelle. Lorsque ce phénomène de court-circuit impédant dépasse une certaine durée, généralement une seconde, il peut provoquer des échauffements importants dans l'organe et/ou dans la ligne d'alimentation. Les dommages de tels échauffements peuvent être irrémédiables, par exemple entraîner la destruction d'un composant ou d'un câble d'alimentation.

Dans des installations stationnaires et notamment dans des installations d'alimentation électrique de machines de puissance, on choisit le type de fusible non seulement selon l'intensité maximale admise sur la ligne électrique ou passant par l'organe, mais on choisit le fusible aussi selon la rapidité avec laquelle le fusible doit réagir.

En ce qui concerne le domaine automobile, la situation est moins confortable puisque les différentes lignes d'alimentation sont généralement réunies sous forme de faisceaux, ce qui favorise, par exemple, un échauffement réciproque des différentes lignes entre elles. De plus, les fusibles utilisés dans les véhicules automobiles exerçant leur fonction par fusion, la coupure d'une ligne d'alimentation ne se produit que lorsque le courant passant par cette ligne dépasse le courant de fusion du fusible.

En dehors de la protection de lignes d'alimentation électrique par des fusibles, on utilise parfois des moyens de protection contre des surcharges électriques destinées à protéger l'organe auquel ils sont attribués contre des surtensions ou éventuellement encore des moyens de protection destinés à couper une ligne d'alimentation lorsque l'organe en question est surchauffé. Dans un cas comme dans l'autre, ces moyens de protection sont destinés à être attribués individuellement à la protection d'un seul organe et en particulier à la protection interne d'un organe tel un moteur électrique. Pour des applications de ce type, ces moyens de protection sont très efficaces, par exemple en cas de blocage du rotor d'un moteur électrique entraînant un surchauffage du bobinage du moteur, mais pas en cas de courts-circuits.

Le document US-P-6 265 891 décrit un dispositif permettant de détecter un court-circuit de bobinage dans un moteur électrique. Toutefois, indépendamment du fait que ce dispositif est conçu de manière à protéger un seul organe, ce dispositif est très complexe, puisque basé sur un calculateur électronique. Un tel dispositif présente le désavantage, outre sa complexité, d'avoir un courant de veille assez important, au moins par rapport à la capacité d'une batterie d'un véhicule automobile qui n'est pas utilisé régulièrement, voire même stocké pendant un certain temps.

Le document EP-A-0 898 173 décrit un dispositif pour détecter des fautes dans un conducteur électrique d'un véhicule.

En effet, la protection efficace des faisceaux électriques d'un véhicule automobile devrait être opérationnelle aussi pendant les périodes de stockage des véhicules automobiles.

Le but de l'invention est de remédier aux inconvénients énoncés ci avant et de proposer un moyen de protection efficace et simple pour la protection des faisceaux électriques d'un véhicule automobile.

Le but de l'invention est atteint avec un dispositif électronique permettant de détecter des anomalies dans des faisceaux électriques d'un véhicule automobile.

Selon l'invention, le dispositif comprend une résistance de mesure permettant de mesurer un courant passant par un faisceau à surveiller, un circuit amplificateur destiné à amplifier des variations de courant dépassant un seuil prédéterminé, un circuit de conditionnement destiné à transformer le profil d'un courant mesuré en une tension représentative d'une énergie à laquelle correspond le courant, et un circuit détecteur permettant de détecter un niveau d'énergie, résultant de l'anomalie, susceptible de causer une blessure du faisceau, ainsi qu'un générateur de signal permettant de réagir à l'anomalie constatée.

Le dispositif de l'invention est fondé sur la détermination de profils de courant exprimés en amplitude et en temps. Ces profils peuvent être mesurés au départ des câbles électriques sur la batterie. Les profils des courants sont ensuite traduits en terme d'énergie équivalente. Lorsque l'énergie équivalente dépasse un seuil prédéterminé, le dispositif dispose de l'information de présence d'un court-circuit impédant et engendre un signal exploitable soit pour alimenter un avertisseur optique ou acoustique, soit pour actionner un coupe-circuit et pour couper ainsi l'alimentation électrique avant que l'échauffement dans le faisceau protégé ne vienne générer des dommages irrémédiables.

Dans ce sens, la présente invention concerne également les caractéristiques ci-après considérées isolément ou sans toute combinaison techniquement possible :
- le dispositif comprend une source lumineuse et le générateur de signal est relié à la source lumineuse ;
- le générateur de signal comprend une sortie de signal permettant de relier le dispositif à un actionneur destiné à couper l'alimentation électrique au moins dans le faisceau surveillé ;
- le générateur de signal comprend une sortie de signal permettant de relier le dispositif à un moyen de commande et/ou de contrôle électronique d'au moins une partie des fonctions disponibles dans un véhicule automobile ;
- le générateur de signal comprend une sortie de signal permettant de relier le dispositif à une source lumineuse ou sonore.

Le but de l'invention est également atteint avec un véhicule automobile équipé d'un dispositif électronique pour détecter des anomalies, qui a les caractéristiques énoncées plus haut et pour lequel les différents seuils évoqués sont déterminés spécifiquement selon l'équipement électrique du véhicule.

D'autres caractéristiques et avantages de la présente invention ressortiront de la description ci-après de l'exemple de réalisation d'un dispositif de l'invention. La description est faite en référence aux dessins annexés dans lesquels
la figure 1 montre un schéma électrique du dispositif de l'invention,
la figure 2 montre un diagramme d'un courant qui n'est pas détecté comme représentatif d'un disfonctionnement ou d'une anomalie et
la figure 3 montre le diagramme d'un court-circuit impédant détecté à la suite d'une blessure de faisceau.

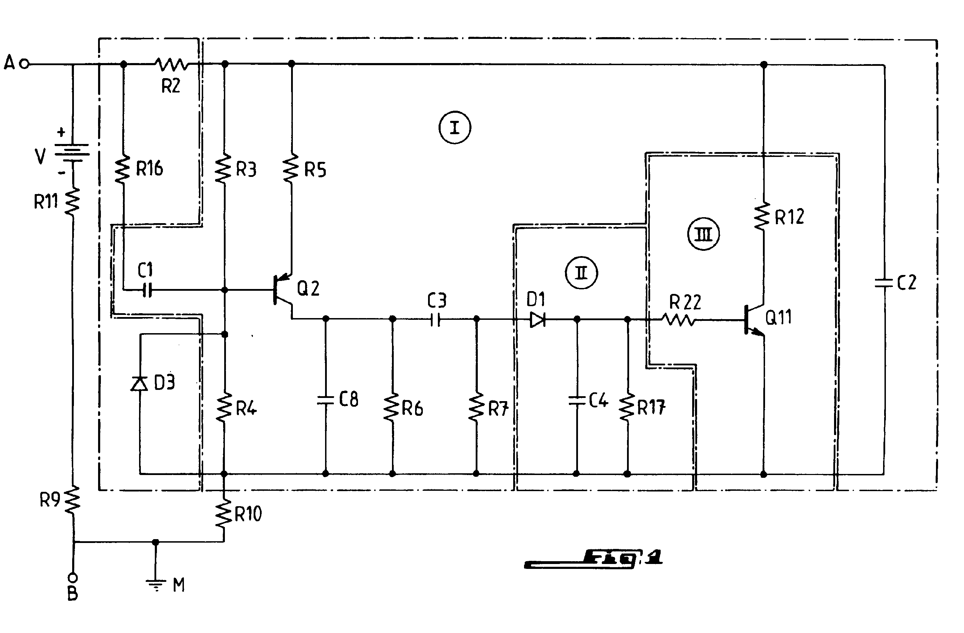

Le dispositif de l'invention peut être réalisé, par exemple, selon le schéma représenté sur la figure 1. Selon ce schéma, le dispositif comprend une résistance de mesure R9 permettant de mesurer un courant passant par un faisceau à surveiller. Le dispositif comprend également un circuit amplificateur I qui est destiné à amplifier des variations de courant dépassant un seuil prédéterminé, ce qui permet d'amplifier uniquement les fortes variations de courant, par exemple des variations supérieures à 30 ampères/microseconde. Le dispositif de l'invention comprend ensuite un circuit de conditionnement II destiné à transformer le profil d'un courant mesuré en une tension représentative d'une énergie à laquelle correspond le courant, et un circuit détecteur III permettant de détecter un niveau d'énergie résultant de l'anomalie et susceptible de causer une blessure du faisceau, notamment une blessure irrémédiable du faisceau.

Le dispositif de l'invention comprend enfin un générateur de signal permettant de réagir à l'anomalie constatée, par exemple en engendrant un signal électrique utilisable directement pour alimenter une lampe témoin ou pour actionner un avertisseur acoustique ou un moyen d'affichage permettant d'afficher par exemple la référence du faisceau dans lequel l'anomalie a été constatée.

Le filtrage et l'intégration dans le circuit permet d'éliminer des variations de courant qui ont pour origine le fonctionnement normal des organes électriques des véhicules, notamment au moment de la mise en marche ou au moment de l'arrêt d'un organe électrique.

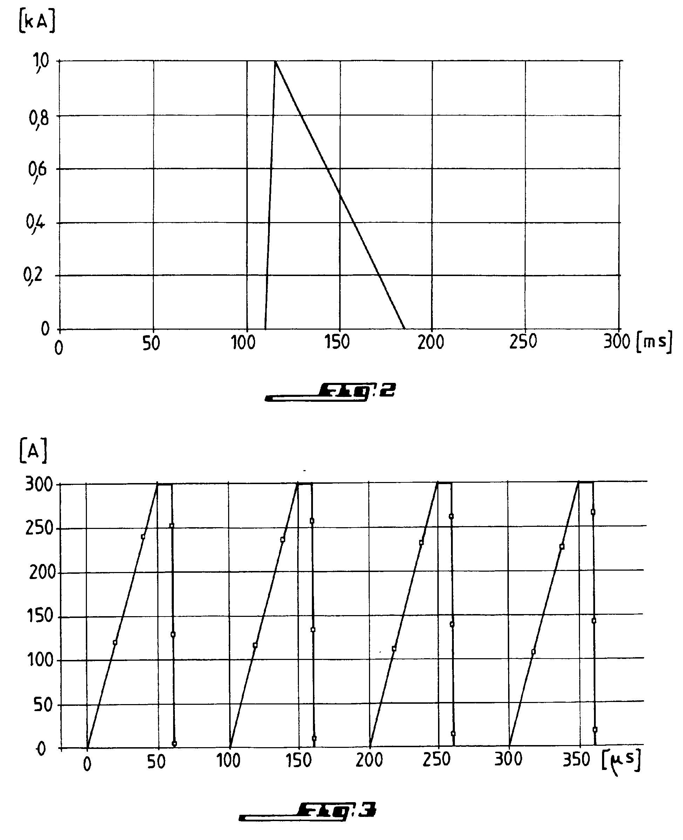

A titre d'exemple pour un courant ne faisant pas état d'une anomalie, la figure 2 montre le profil d'un courant démarreur avec une amplitude de 1000 ampères, un temps de montée de 5 millisecondes, un temps de descente de 70 millisecondes et une durée de stabilisation d'1 microseconde.

La figure 3 représente un exemple d'un court-circuit impédant détecté à la suite d'une blessure de faisceau avec un courant d'une amplitude de 300 ampères, un temps de montée de 50 microsecondes, un temps de descente d'1 microseconde, une durée de stabilisation de 10 microsecondes et une période de 100 microsecondes.

Le dispositif de l'invention permet de détecter ainsi au travers d'un seuil paramétrable, qui est fonction des valeurs des résistances R12 et R22 du circuit représenté sur la figure 1, un niveau d'énergie représentant une blessure de faisceau.

Lorsque le dispositif détecte une blessure de faisceau engendrant un court-circuit impédant franc, il peut transmettre l'information à un avertisseur optique ou acoustique installé par exemple sur le tableau de bord du véhicule automobile. Mais il peut également transmettre cette information vers une unité centralisée pour informer le conducteur du véhicule automobile au travers d'un gestionnaire et afficheur d'information du véhicule afin que le conducteur arrête le véhicule en urgence, tout comme le dispositif peut transmettre l'information aussi à l'actionneur destiné à couper l'alimentation générale du véhicule, notamment lorsque l'envergure de la blessure du faisceau ou de plusieurs faisceaux dépasse une valeur prédéterminée.

Un grand avantage du dispositif de l'invention est qu'il est entièrement autonome et notamment indépendant de l'ensemble des organes du véhicule. Le dispositif de l'invention assure une protection de l'ensemble des lignes d'alimentation d'un véhicule automobile sur toutes les phases de vie du véhicule (parc, stockage, roulage ...).

Le dispositif de l'invention, associé à un contacteur, permet enfin de supprimer des fusibles dont l'efficacité n'est pas garantie ou qui ne sont efficaces qu'en présence de courts-circuits francs ou de chocs intervenant sur le véhicule automobile.

## Revendications

1. Dispositif électronique permettant de détecter des anomalies dans des faisceaux électriques d'un véhicule automobile et de protéger ces faisceaux électriques, comprenant une résistance de mesure (R9) permettant de mesurer un courant de fonctionnement passant par un faisceau à surveiller, un circuit amplificateur (I) destiné à amplifier des variations de courant dépassant un seuil prédéterminé, un circuit de conditionnement (II) destiné à transformer le profil d'un courant mesuré en une tension représentative d'une énergie à laquelle correspond le courant de manière à éliminer des variations de courant qui ont pour origine le fonctionnement normal des organes électriques du véhicule, et un circuit détecteur (III) permettant de détecter un niveau d'énergie, résultant de l'anomalie, susceptible de causer une blessure du faisceau, ainsi qu'un générateur de signal permettant de réagir à l'anomalie constatée.

2. Dispositif selon la revendication 1, **caractérisé en ce que** la transformation d'un profil d'un courant mesuré en une tension représentative d'une énergie à laquelle correspond le courant est destinée à être effectuée par intégration.

3. Dispositif selon l'une quelconque des revendications 1 à 2, **caractérisé en ce qu'**il comprend une source lumineuse et **en ce que** le générateur de signal est relié à la source lumineuse.

4. Dispositif selon l'une quelconque des revendications 1 à 3, **caractérisé en ce que** le générateur de signal comprend une sortie de signal permettant de relier le dispositif à un actionneur destiné à couper l'alimentation électrique au moins dans le faisceau surveillé.

5. Dispositif selon l'une quelconque des revendications 1 à 4, **caractérisé en ce que** le générateur de signal comprend une sortie de signal permettant de relier le dispositif à un moyen de commande et/ou de contrôle électronique d'au moins une partie des fonctions disponibles dans un véhicule automobile.

6. Dispositif selon la revendication 1, **caractérisé en ce que** le générateur de signal comprend une sortie de signal permettant de relier le dispositif à une source lumineuse ou sonore.

7. Véhicule automobile, **caractérisé en ce qu'**il comprend un dispositif selon l'une quelconque des revendications 1 à 6.

## Claims

1. Electronic device making it possible to detect anomalies in electrical harnesses of a motor vehicle and to protect these electrical harnesses, comprising a measurement resistor (R9) making it possible to measure an operating current passing through a harness to be monitored, an amplifier circuit (I) intended to amplify variations in current exceeding a predetermined threshold, a conditioning circuit (II) intended to transform the profile of a measured current into a voltage representative of an energy to which the current corresponds so as to eliminate variations in current which originate from the normal operation of the electrical members du vehicle, and a detector circuit (III) making it possible to detect an energy level, resulting from the anomaly, liable to cause an impairment to the harness, as well as a signal generator making it possible to react to the noted anomaly.

2. Device according to Claim 1, **characterized in that** the transformation of a profile of a measured current into a voltage representative of an energy to which the current corresponds is intended to be performed by integration.

3. Device according to any one of Claims 1 to 2, **characterized in that** it comprises a light source and **in that** the signal generator is linked to the light source.

4. Device according to any one of Claims 1 to 3, **characterized in that** the signal generator comprises a signal output making it possible to link the device to an actuator intended to cut off the electrical power supply at least in the monitored harness.

5. Device according to any one of Claims 1 to 4, **characterized in that** the signal generator comprises a signal output making it possible to link the device to an electronic command and/or control means for at least some of the functions available in a motor vehicle.

6. Device according to Claim 1, **characterized in that** the signal generator comprises a signal output making it possible to link the device to a light source or audible source.

7. Motor vehicle, **characterized in that** it comprises a device according to any one of Claims 1 to 6.

## Patentansprüche

1. Elektronische Vorrichtung, die es ermöglicht, Anomalien in Kabelbäumen eines Kraftfahrzeugs zu erfassen und diese Kabelbäume zu schützen, die einen Messwiderstand (R9), der es ermöglicht, einen Betriebsstrom zu messen, der durch einen zu überwachenden Kabelbaum geht, eine Verstärkerschaltung (I), die dazu bestimmt ist, Stromschwankungen zu verstärken, die einen vorbestimmten Schwellwert überschreiten, eine Konditionierungsschaltung (II), die dazu bestimmt ist, das Profil eines gemessenen Stroms in eine Spannung umzuwandeln, die für eine Energie repräsentativ ist, der der Strom entspricht, um Stromschwankungen zu unterdrücken, die als Ursprung den normalen Betrieb der elektrischen Organe des Fahrzeugs haben, und eine Detektorschaltung (III), die es ermöglicht, einen Energiepegel zu erfassen, der aus der Anomalie resultiert und eine Verletzung des Kabelbaums verursachen kann, sowie einen Signalgenerator aufweist, der es ermöglicht, auf die festgestellte Anomalie zu reagieren.

2. Vorrichtung nach Anspruch 1, **dadurch gekennzeichnet, dass** die Umwandlung eines Profils eines gemessenen Stroms in eine Spannung, die für eine Energie repräsentativ ist, der der Strom entspricht, dazu bestimmt ist, durch Integration durchgeführt zu werden.

3. Vorrichtung nach einem der Ansprüche 1 bis 2, **dadurch gekennzeichnet, dass** sie eine Lichtquelle aufweist, und dass der Signalgenerator mit der Lichtquelle verbunden ist.

4. Vorrichtung nach einem der Ansprüche 1 bis 3, **dadurch gekennzeichnet, dass** der Signalgenerator einen Signalausgang aufweist, der es ermöglicht, die Vorrichtung mit einem Stellglied zu verbinden, das dazu bestimmt ist, die Stromversorgung zumindest in dem überwachten Kabelbaum zu unterbrechen.

5. Vorrichtung nach einem der Ansprüche 1 bis 4, **dadurch gekennzeichnet, dass** der Signalgenerator einen Signalausgang aufweist, der es ermöglicht, die Vorrichtung mit einer elektronischen Steuer-und/oder Überwachungseinrichtung mindestens eines Teils der Funktionen zu verbinden, die in einem Kraftfahrzeug zur Verfügung stehen.

6. Vorrichtung nach Anspruch 1, **dadurch gekennzeichnet, dass** der Signalgenerator einen Signalausgang aufweist, der es ermöglicht, die Vorrichtung mit einer Licht- oder Schallquelle zu verbinden.

7. Kraftfahrzeug, **dadurch gekennzeichnet, dass** es eine Vorrichtung nach einem der Ansprüche 1 bis 6 aufweist.
